# EUROPÄISCHE PATENTSCHRIFT

(11) **EP 0 630 744 B1**
(45) Veröffentlichungstag und Bekanntmachung des Hinweises auf die Patenterteilung: **19.05.1999**
(21) Anmeldenummer: 94201697.3
(22) Anmeldetag: 14.06.1994
(51) Int. Cl.: B32B 15/04, B22F 3/12, C23C 16/30, B23B 27/14

(54) **Schneidwerkstoff zum Fräsen von Metallen**
Cutting material for cutting metal
Matériel de coupage pour le fraisage de métaux

(30) Priorität: 21.06.1993 AT 1208/93
(43) Veröffentlichungstag der Anmeldung: 28.12.1994
(73) Patentinhaber: PLANSEE TIZIT GESELLSCHAFT M.B.H., 6600 Reutte/Tirol (AT)
(72) Erfinder: Schintlmeister, Wilfried, Dr., A-6600 Reutte (AT); Schmid, Lothar, A-6600 Höfen (AT); Wallgram, Wolfgang, A-6600 Breitenwang (AT)
(74) Vertreter: Lohnert, Wolfgang, Dr.

(56) Entgegenhaltungen:
- EP-A- 0 392 519
- WO-A-90/11156
- US-A- 4 708 037

## Beschreibung

Die Erfindung betrifft einen Schneidwerkstoff zum Fräsen von Metallen, bestehend aus einem Hartmetall-Grundkörper der Zusammensetzung 5,5 - 14 Gew.% Kobalt, bis zu 20 Gew.% von einem oder mehreren Zusatzkarbiden der Metalle der Gruppe IV A und V A des Periodensystems der Elemente, wobei im Falle eines Kobaltgehaltes von weniger als 7,5 Gew.% der Anteil der Zusatzkarbide weniger als 5 Gew.% beträgt, Rest Wolframkarbid, sowie aus einer auf dem Hartmetall-Grundkörper aufgebrachten Beschichtung mit einer Gesamtschichtdicke von 2 - 7 µm und, ausgehend vom Hartmetall-Grundkörper, folgendem Schichtaufbau:
- eine ein- oder mehrlagige Unterlagsschicht aus Titankarbonitrid und/oder Titannitrid, wahlweise mit Sauerstoff- und/oder Boranteilen
- eine ein- oder mehrlagige Deckschicht aus einem oder mehreren Oxiden, ausgewählt aus der Gruppe Aluminiumoxid, Zirkonoxid oder deren Mischungen, wahlweise mit Titan- und/oder Boranteilen und wahlweise im Wechsel mit Hartstoffschichten aus der Gruppe Titankarbid, Titannitrid, Titanborid, Titanoxid oder deren Mischungen, wobei der Grundkörper eine Koerzitiv-Feldstärke mit Werten zwischen 6,37.10³ und 14,32.10³ A/m aufweist und der an die Deckschicht angrenzende Bereich der Unterlagsschicht stickstoffreich ist mit einem Stickstoff-Mindestanteil von 40 Atom%.

In einer Variante betrifft die Erfindung einen Schneidwerkstoff zum Fräsen entsprechend dem Oberbegriff des Anspruches 2.

Das Beschichten von Schneidwerkstoffen aus Hartmetall oder anderen Materialien mit Hartstoffschichten zur Verbesserung der Standzeit bei der spanabhebenden Bearbeitung ist seit vielen Jahren bekannt. Insbesondere haben sich Hartstoffschichten aus Titankarbid, Titankarbonitrid, Titannitrid und Aluminiumoxid bewahrt, wobei die einzelnen Hartstoffschichten ein unterschiedliches Verschleißverhalten aufweisen. So haben beispielsweise Titannitrid und Aluminiumoxid eine hohe chemische Stabilität gegenüber Eisen und wirken auch als Diffusionsbarriere gegenüber Kohlenstoff und Bindemetall (Kobalt) und vermindern dadurch in Verbindung mit ihrer Oxidationsbeständigkeit den Kolkverschleiß. Titankarbid wiederum weist eine sehr große Härte auf und bewirkt damit einen hohen Widerstand gegen den Freiflächenverschleiß. Da Je nach Zerspanungsoperation und Art des zu zerspanenden Werkstoffes unterschiedliche Verschleißbeanspruchungen auftreten, ist es zum Erreichen eines möglichst günstigen Standzeit-Verhaltens daher wichtig, daß der verwendete Schneidwerkstoff sowohl hinsichtlich des Materiales des Grundkörpers als auch hinsichtlich Art und Dicke der verwendeten Hartstoffbeschichtung sorgfältig auf das zu zerspanende Material und auf die Zerspanungsbedingungen abgestimmt wird. Vielfach führt nur eine Kombination verschiedener Hartstoffschichten in Verbindung mit einem ganz speziellen Grundkörper zu dem gewünschten Erfolg.

Die EP 0 392 519 beschreibt beispielsweise einen Schneidwerkstoff aus einem Hartmetall-Grundwerkstoff auf kobaltgebundener Wolframkarbidbasis und einem Überzug mit ein- oder mehrlagigem Hartstoff-Schichtaufbau. Zur Verbesserung der Überzugshaftung weist die Randzone des Grundwerkstoffes einen gegenüber der Kernzone verringerten Kobaltgehalt auf. In den Beispielen dieser Veröffentlichung ist unter anderem auch eine Schneidstoffausführung genannt, bestehend aus einem Grundkörper aus 8 Gew.% Co, 2 Gew.% TaC, Rest WC und einem Überzug der Schichtfolge - anschließend an den Grundkörper: 3 µm starke TiC-Schicht, 1 µm starke TiCN-Schicht und 1 µm starke Deckschicht aus Al₂O₃.
In einer weiteren Ausführungsform ist der Schneidwerkstoff wie oben ausgeführt, Jedoch mit dem Unterschied, daß die Al₂O₃-Schicht nur 0,5 µm stark ausgeführt ist und darauf noch eine 0,5 µm starke TiN-Schicht aufgebracht ist.
Aus den in der Beschreibung genannten Beschichtungsbedingungen ist zu entnehmen, daß die TiCN-Schicht kohlenstoffreich ist. Eine besondere Eignung der genannten Schneidwerkstoffe ist der Beschreibung nicht zu entnehmen.

Die jeweiligen Eigenschaften der unterschiedlichen Hartstoffschichten gelten sowohl für das Drehen als auch für das Fräsen. Die periodischen, thermischen und mechanischen Lastwechsel beim Fräsen erfordern es, daß Grundkörper und Hartstoffschichten hinsichtlich Wärmeleitfähigkeit, Wärmedehnung, E-Modul und Bruchfestigkeit noch sorgfältiger als bei Schneidwerkstoffen zum Drehen aufeinander abgestimmt werden. Insbesondere ist beim Fräsen die Gesamtdicke des Schichtaufbaues in der Praxis aus Gründen der Elastizität und Haftung mit etwa 7 µm begrenzt. Bei Drehwerkzeugen liegt die Gesamtdicke des Schichtaufbaus typischerweise im Bereich zwischen 10 und 12 µm.

Für das Fräsen von Stahl einerseits und Eisengußwerkstoffen andererseits war es bisher üblich, unterschiedliche Schneidstoffsorten sowohl im Hinblick auf den Schichtaufbau als auch bezüglich des Grundmaterials zu verwenden.

Zum Fräsen von Eisengußwerkstoffen wurden in der Regel als Grundmaterial Hartmetallsorten auf einer feinkörnigen Wolframkarbidbasis mit niederem Kobaltgehalt und wenig zusätzlichen Karbiden mit hohen Koerzitivfeldstärken von 15,92.10³ A/m aufwärts sowie mit ein oder mehreren Lagen von insbesondere aluminiumoxidhältigen Hartstoffschichten verwendet.

Bei der Fräsbearbeitung von Stahlwerkstoffen wurden hingegen in erster Linie Hartmetallsorten auf grobkörniger Wolframkarbidbasis mit vergleichsweise höherem Kobaltgehalt und mehr zusätzlichen Karbiden mit geringen Koerzitivfeldstärken von max. 150 Oe mit ein oder mehreren Lagen von Titankarbid, Titankarbonitrid und/oder Titannitrid Hartstoffschichten, jedoch ohne aluminiumoxidhältige Schichten, eingesetzt.

Diese unterschiedlichen Schneidwerkstoffe für das Fräsen von Stahl und Eisengußwerkstoffen waren notwendig, da die für die Stahlzerspanung optimalen Schneidwerkstoffe beim Fräsen von Eisenguß zu wenig verschleißfest und für plastische Verformung anfällig sind, während die für die Eisenguß-Zerspanung verwendeten Schneidwerkstoffe für die Stahlzerspanung aufgrund der geringeren Zähigkeit vorzeitig durch Bruch ausfallen.

Bedingt durch diese erforderliche große Zahl von unterschiedlichen Schneidwerkstoffen ergibt sich beim Anwender ein hoher logistischer Aufwand. Es besteht somit der Wunsch, die Vielfalt der in der Praxis angebotenen Schneidwerkstoffe auf ein überschaubares Minimum einzuschränken.

Die WO90/11156 beschreibt einen Schneideinsatz aus einem Grundkörper und einer Hartstoffbeschichtung. Der Grundkörper besteht aus Hartmetall auf Wolframkarbidbasis mit Mischkarbidanteilen und Kobaltgehalten zwischen 6,1 und 6,5 Gew.% mit einer Härte von wenigstens 90,8 bis 91,6 Rockwell A und einer Koerzitiv-Feldstärke von 8,76.10³ A/m bis 14,32.10³ A/m.
Die Hartstoffbeschichtung besteht aus einer mindestens 5 µm starken Unterlagsschicht aus einem Karbid und/oder Karbonitrid von einem oder mehreren der Metalle Titan, Hafnium und Zirkon, die direkt auf dem Grundkörper aufgebracht ist, einer auf der Unterlagsschicht angeordneten Aktivschicht mit wechselnden Teilschichten, die zumindest eine Mehrzahl von Aluminiumoxidschichten umfassen, die wiederum jeweils durch Titan-, Zirkon- und/oder Hafniumnitridschichten voneinander getrennt sind, sowie aus einer Oberflächenschicht aus einem Nitrid und/oder Karbonitrid von einem oder mehreren der Metalle Titan, Hafnium und Zirkon, die auf die äußerste Aluminiumoxidschicht aufgebracht ist. Die Gesamtschichtstärke der Hartstoffbeschichtung liegt vorzugsweise zwischen 7,5 µm und 20 µm. Diese Art eines Schneideinsatzes ist zwar sehr gut zum Drehen von unterschiedlichen Materialien auch bei unterbrochenem Schnitt geeignet, für eine echte Fräsbearbeitung ist er jedoch nur schlecht verwendbar.

Aufgabe der vorliegenden Erfindung ist es daher, eine beschichtete Hartmetallsorte zum Fräsen zur Verfügung zu stellen, die sowohl die vorteilhafte Bearbeitung von Stahl als auch von Eisengußwerkstoffen mit hohen Standzeiten ermöglicht.

Erfindungsgemäß wird dies dadurch erreicht, daß die Gesamtschichtstärke der Unterlagsschicht 0,5 - 3 µm beträgt.

Für die erfindungsgemäße Variante wird dies dadurch erreicht, daß die unmittelbar an die Deckschicht angrenzende Teilschicht der Unterlagsschicht eine Titannitridschicht ist.

Für den erfindungsgemäßen Schneidwerkstoff ist wesentlich, daß zum einen die mittlere Korngröße des Grundkörpers und der Anteil der neben dem Wolframkarbid vorhandenen zusätzlichen Karbide genau aufeinander abgestimmt sind und daß überraschenderweise zum anderen erst wenn der an die Deckschicht angrenzende Bereich der Unterlagsschicht aus einer ein- oder mehrlagigen Titannitrid- oder einer stickstoffreichen Titankarbonitridschicht besteht, in Kombination mit einer oxidischen Deckschicht Verschleißeigenschaften erreicht werden, die den Schneidwerkstoff in hervorragender Weise sowohl zum Fräsen von Stahl als auch von Eisenguß geeignet machen.

Die speziell abgestimmte mittlere Korngröße des Grundkörpers ist durch die Koerzitiv-Feldstärke innerhalb spezieller Grenzen charakterisiert. Die Koerzitiv-Feldstärke läßt sich leichter und eindeutiger ermitteln als die geometrische mittlere Korngröße selbst. Diese Charakterisierung ist zielführend, da die Koerzitiv-Feldstärke des Grundkörpers für jeweils stofflich gleichartiges und anteilsmäßig vergleichbares Bindemetall praktisch ausschließlich von der Korngröße des Grundkörpers bestimmt wird.

Ein besonders vorteilhafter Schneidstoff ergibt sich, wenn im Falle eines Zusatzkarbid-Anteils von 5 - 15 Gew.% und eines Kobalt-Anteils von 8 - 12 Gew.% die mittlere Korngröße des Grundkörpers so eingestellt wird, daß die Koerzitiv-Feldstärke Werte zwischen 7,96.10³ und 12,73.10³ A/m aufweist. Bei einem Zusatzkarbid-Anteil von weniger als 3 Gew.% und einem Kobaltgehalt von 5,5 - 7 Gew.% wird die mittlere Korngröße des Grundkörpers vorteilhafterweise so eingestellt, daß die Koerzitiv-Feldstärke zwischen 9,55.10³ und 12,73.10³ A/m liegt.

Insbesondere hat es sich bewährt, wenn die an den Grundkörper angrenzende Unterlagsschicht aus einer oder mehreren Lagen aus Titankarbonitrid mit oder ohne unmittelbar am Grundkörper angeordneter Titannitridschicht besteht.

Für die Unterlagsschicht ist es vorteilhaft, wenn der unmittelbar an die Deckschicht angrenzende Bereich einen ein- oder mehrlagigen Schichtaufbau, bestehend aus Titannitrid und/oder Titankarbonitrid mit einem Stickstoffgehalt von mindestens 45 Atom% und einer Gesamtschichtstärke von 0,5 - 3 µm, aufweist.

Als Deckschicht wiederum ist eine ein- oder mehrlagige Aluminiumoxidschicht, gegebenenfalls im Wechsel mit einer Titanoxinitrid- oder Titanoxikarbonitridschicht mit einer Gesamtschichtstärke zwischen 0,5 und 5 µm von Vorteil.

Für die Herstellung des Grundkörpers des Schneidwerkstoffes ist es empfehlenswert, das Wolframkarbidpulver mit einer mittleren Korngröße zwischen 1,5 µm und 8 µm, das Kobaltpulver mit einer mittleren Korngröße zwischen 1 µm und 3 µm und die Zusatzkarbidpulver mit einer mittleren Korngröße zwischen 1 µm und 3 µm im Attritor zwischen 5 und 15 Stunden zu mahlen, zu pressen sowie bei 1400 - 1500°C zwischen 30 und 120 Minuten zu sintern und den Grundkörper anschließend mittels CVD-, Plasma-CVD- oder PVD-Verfahren zu beschichten.

Im folgenden wird die Erfindung anhand von Herstellungsbeispielen und Zerspanungstests näher erläutert.

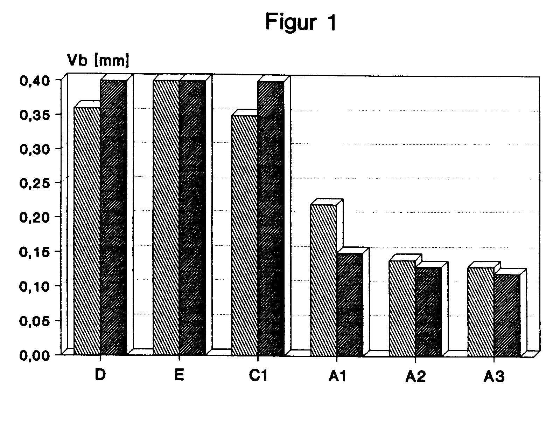

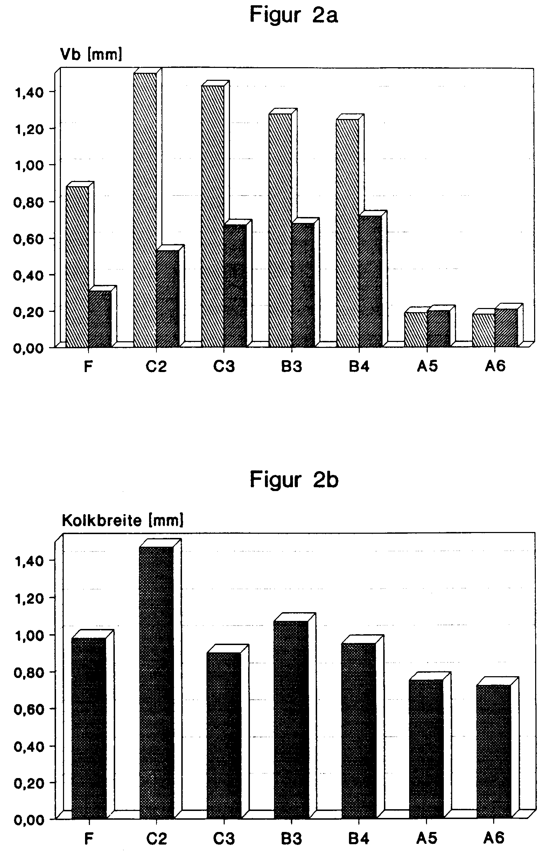

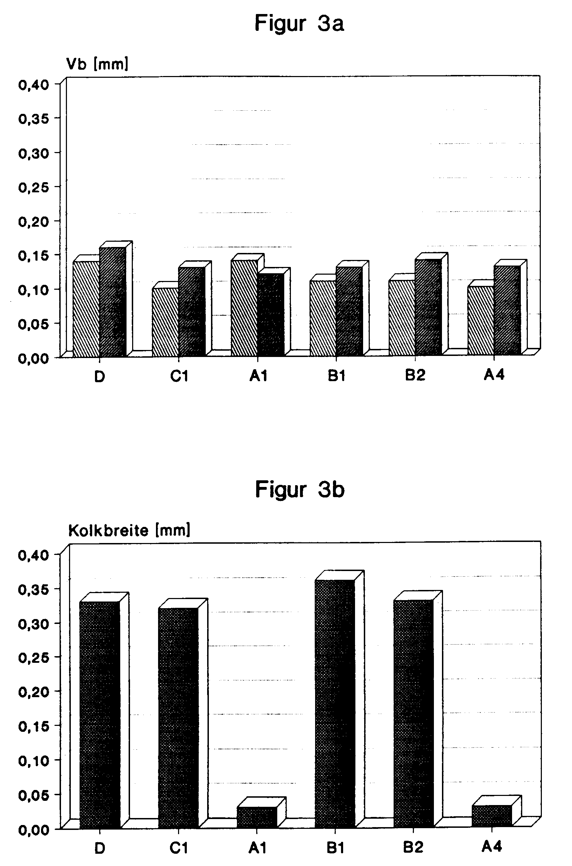

Die Figuren 1, 2a, 3a und 4 zeigen den Freiflächenverschleiß einzelner, nach den Herstellungsbeispielen gefertigter Muster nach vergleichenden Zerspanungstests in Form von Balkendiagrammen, wobei die eng schraffierten Balken die Verschleißmarkenbreite am Eckenradius und die weiter schraffierten Balken die Verschleißmarkenbreite an der Hauptschneide wiedergeben. Die punktierten Balken der Figuren 2b und 3b stellen den aufgetretenen Kolkverschleiß dar.

### HERSTELLUNGSBEISPIELE

Zur Untersuchung des Verschleißverhaltens wurden eine Anzahl unterschiedlicher Muster von Wendeschneidplatten nach Tabelle 1 hergestellt.

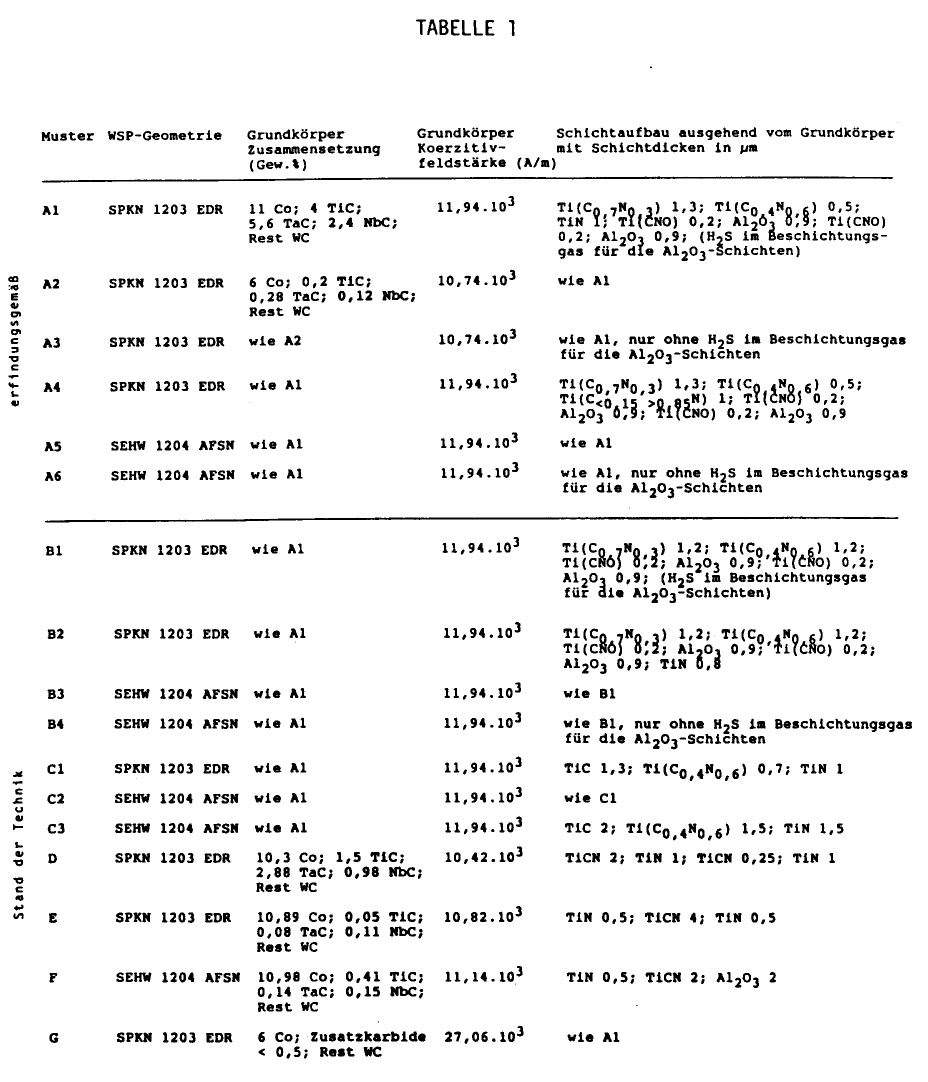

Zur Beschichtung nach dem CVD-Verfahren wurden die Wendeschneidplatten in einen Rezipienten eingebaut, unter Schutzgas aufgeheizt und unter Normaldruck die einzelnen Schichten mit den folgenden Parametern aufgebracht:

### MUSTER A1, A2, A5

Ti(C_{0,7}N_{0,3})-Schicht

| | |
|---|---|
| Gaszusammensetzung: | 68,5 Vol.% H₂ |
| | 2,3 Vol.% TiCl₄ |
| | 3,1 Vol.% N₂ |
| | 6,2 Vol.% CH₄ |
| | 19,9 Vol.% Ar |
| Beschichtungstemperatur: | 1020°C |
| Beschichtungszeit: | 17 min. |

Ti(C_{0,4}N_{0,6})-Schicht

| | |
|---|---|
| Gaszusammensetzung: | 67,2 Vol.% H₂ |
| | 2,3 Vol.% TiCl₄ |
| | 6,1 Vol.% N₂ |
| | 4,9 Vol.% CH₄ |
| | 19,5 Vol.% Ar |
| Beschichtungstemperatur: | 1010°C |
| Beschichtungszeit: | 7 min. |

TiN-Schicht

| | |
|---|---|
| Gaszusammensetzung: | 46,5 Vol.% H₂ |
| | 2,0 Vol.% TiCl₄ |
| | 42,2 Vol.% N₂ |
| | 9,3 Vol.% Ar |
| Beschichtungstemperatur: | 995°C |
| Beschichtungszeit: | 10 min. |

Ti(CNO)-Schichten, jeweils pro Schicht

| | |
|---|---|
| Gaszusammensetzung: | 64 Vol.% H₂ |
| | 2,2 Vol.% TiCl₄ |
| | 8,1 Vol.% N₂ |
| | 4,7 Vol.% CH₄ |
| | 0,05 Vol.% CO₂ |
| | 20,95 Vol.% Ar |
| Beschichtungstemperatur: | 1010°C |
| Beschichtungszeit: | 5 min. |

Al₂O₃-Schichten, jeweils pro Schicht

| | |
|---|---|
| Gaszusammensetzung: | 4,66 Vol.% H₂ |
| | 42,7 Vol.% N₂ |
| | 4,3 Vol.% HCl |
| | 2,1 Vol.% CO₂ |
| | 46,1 Vol.% Ar |
| | 0,08 Vol.% BCl₃ |
| | 0,06 Vol.% H₂S |
| Beschichtungstemperatur: | 1010°C |
| Beschichtungszeit: | 35 min. |

### MUSTER A3, A6

Gleiche Beschichtungsbedingungen wie bei den Mustern A1, A2, A5 mit Ausnahme der Al₂O₃-Schichten, die unter den folgenden Bedingungen abgeschieden wurden:

| | |
|---|---|
| Gaszusammensetzung: | 8,76 Vol.% H₂ |
| | 50,9 Vol.% N₂ |
| | 4,78 Vol.% HCl |
| | 3,5 Vol.% CO₂ |
| | 31,9 Vol.% Ar |
| | 0,16 Vol.% BCl₃ |
| Beschichtungstemperatur: | 1050°C |
| Beschichtungszeit: | 65 min. |

### MUSTER A4

Gleiche Beschichtungsbedingungen wie bei den Mustern A1, A2, A5 mit der Ausnahme, daß die stickstoffreiche Ti(C_{<0,15}N_{>0,85})-Schicht anstelle der TiN-Schicht unter den folgenden Bedingungen abgeschieden wurde:

| | |
|---|---|
| Gaszusammensetzung: | 70,2 Vol.% H₂ |
| | 2,4 Vol.% TiCl₄ |
| | 15,3 Vol.% N₂ |
| | 1,9 Vol.% CH₄ |
| | 10,2 Vol.% Ar |
| Beschichtungstemperatur: | 990°C |
| Beschichtungszeit: | 12 min. |

### MUSTER B1, B3

Ti(C_{0,7}N_{0,3})-Schicht

| | |
|---|---|
| Gaszusammensetzung: | 68,5 Vol.% H₂ |
| | 2,3 Vol.% TiCl₄ |
| | 3,1 Vol.% N₂ |
| | 6,2 Vol.% CH₄ |
| | 19,9 Vol.% Ar |
| Beschichtungstemperatur: | 1020°C |
| Beschichtungszeit: | 16 min. |

Ti(C_{0,4}N_{0,6})-Schicht

| | |
|---|---|
| Gaszusammensetzung: | 67,2 Vol.% H₂ |
| | 2,3 Vol.% TiCl₄ |
| | 6,1 Vol.% N₂ |
| | 4,9 Vol.% CH₄ |
| | 19,5 Vol.% Ar |
| Beschichtungstemperatur: | 1010°C |
| Beschichtungszeit: | 13 min. |

Ti(CNO)-Schichten und Al₂O₃-Schichten wie bei den Mustern A1, A2, A5.

### MUSTER B2

Gleiche Beschichtungsbedingungen wie bei Mustern B1, B3 mit Ausnahme der zusätzlichen TiN-Deckschicht:

| | |
|---|---|
| Gaszusammensetzung: | 68 Vol.% H₂ |
| | 2,3 Vol.% TiCl₄ |
| | 29,7 Vol.% N₂ |
| Beschichtungstemperatur: | 920°C |
| Beschichtungszeit: | 25 min. |

### MUSTER B4

Ti(C_{0,7}N_{0,3})-Schicht und Ti(C_{0,4}N_{0,6})-Schicht wie bei Mustern B1,B3.
Ti(CNO)-Schichten und Al₂O₃-Schichten wie bei Mustern A3,A6.

### MUSTER C1, C2

TiC-Schicht

| | |
|---|---|
| Gaszusammensetzung: | 75,4 Vol.% H₂ |
| | 2,6 Vol.% TiCl₄ |
| | 11 Vol.% CH₄ |
| | 11 Vol.% Ar |
| Beschichtungstemperatur: | 1030°C |
| Beschichtungszeit: | 10 min. |

Ti(C_{0,4}N_{0,6})-Schicht

| | |
|---|---|
| Gaszusammensetzung: | 73,9 Vol.% H₂ |
| | 2,5 Vol.% TiCl₄ |
| | 8,1 Vol.% N₂ |
| | 4,7 Vol.% CH₄ |
| | 10,8 Vol.% Ar |
| Beschichtungstemperatur: | 1030°C |
| Beschichtungszeit: | 12 min. |

TiN-Schicht

| | |
|---|---|
| Gaszusammensetzung: | 68 Vol.% H₂ |
| | 2,3 Vol.% TiCl₄ |
| | 29,7 Vol.% N₂ |
| Beschichtungstemperatur: | 920°C |
| Beschichtungszeit: | 28 min. |

### MUSTER C3

TiC-Schicht

| | |
|---|---|
| Gaszusammensetzung: | 77,1 Vol.% H₂ |
| | 2,6 Vol.% TiCl₄ |
| | 9,1 Vol.% CH₄ |
| | 11,2 Vol.% Ar |
| Beschichtungstemperatur: | 1030°C |
| Beschichtungszeit: | 25 min. |

Ti(C_{0,4}N_{0,6})-Schicht:

| | |
|---|---|
| Gaszusammensetzung: | 73,9 Vol.% H₂ |
| | 2,5 Vol.% TiCl₄ |
| | 8,1 Vol.% N₂ |
| | 4,7 Vol.% CH₄ |
| | 10,8 Vol.% Ar |
| Beschichtungstemperatur: | 1030°C |
| Beschichtungszeit: | 25 min. |

TiN-Schicht:

| | |
|---|---|
| Gaszusammensetzung: | 68 Vol.% H₂ |
| | 2,3 Vol.% TiCl₄ |
| | 29,7 Vol.% N₂ |
| Beschichtungstemperatur: | 920°C |
| Beschichtungszeit: | 45 min. |

### MUSTER D, E, F

Bei diesen Mustern handelte es sich um zugekaufte, am Markt erhältliche Konkurrenzprodukte.

### ZERSPANUNGSTESTS

In einem ersten Zerspanungstest wurde Sphäroguß GGG50, Härte 230 HB, mit einer Schnittgeschwindigkeit von 400 m/min., einem Vorschub von 0,25 mm/U und einer Schnittiefe von 2 mm jeweils unter Verwendung der Muster-Wendeschneidplatten A1, A2, A3, C1, D und E über eine Länge von 800 mm trockengefräst und der Verschleiß der einzelnen Muster miteinander verglichen. Aus Figur 1 ist der Freiflächenverschleiß der einzelnen Muster zu entnehmen, wobei die eng schraffierten Balken die Verschleißmarkenbreite am Eckenradius und die weiter schraffierten Balken die Verschleißmarkenbreite an der Hauptschneide wiedergeben.

Die erfindungsgemäßen Muster A1, A2, A3 zeigten gegenüber den Mustern C1, D und E, die keine oxidische Deckschicht aufweisen, einen deutlich geringeren Freiflächenverschleiß. Der Kolkverschleiß war bei allen Mustern vernachlässigbar klein.

In einem zweiten Zerspanungstest wurde Kohlenstoffstahl (CK60) mit einer Schnittgeschwindigkeit von 320 m/min., einem Vorschub von 0,35 mm/U und einer Schnittiefe von 3 mm jeweils unter Verwendung der Muster-Wendeschneidplatten A5, A6, B3, B4, C2, C3 und F über eine Länge von 800 mm trockengefräst und der aufgetretene Verschleiß der einzelnen Muster miteinander verglichen.
Aus Figur 2a ist der Freiflächenverschleiß zu entnehmen.
Es ist klar zu erkennen, daß durch die TiN-Schicht unterhalb der Deckschicht der erfindungsgemäßen Muster A5 und A6 der Freiflächenverschleiß gegenüber den Mustern B3, B4 und F deutlich herabgesetzt wurde.

Die Figur 2b zeigt den Kolkverschleiß, der bei den erfindungsgemäßen Mustern A5 und A6 ebenfalls etwas geringer als gegenüber den Mustern B3, B4, C2, C3 und F war.

In einem dritten Zerspanungstest wurde Kohlenstoffstahl (CK60) mit einer Schnittgeschwindigkeit von 270 m/min., einem Vorschub von 0,25 mm/U und einer Schnittiefe von 2 mm jeweils unter Verwendung der Muster-Wendeschneidplatten A1, A4, B1, B2, C1 und D über eine Länge von 800 mm trockengefräst und der Verschleiß der einzelnen Muster miteinander verglichen.
Aus Figur 3a ist der Freiflächenverschleiß zu entnehmen.
Die Figur 3b zeigt wiederum den Kolkverschleiß, der bei den erfindungsgemäßen Mustern A1 und A4 sehr gering war, während bei den Mustern B1, B2, C1 und D ein starker Kolk festzustellen war.

Aus einem Vergleich der ersten und dritten Zerspanungstests ist zu ersehen, daß das dem Stand der Technik entsprechende Muster D gegenüber dem erfindungsgemäßen Muster A1 beim Fräsen von Stahl einen zwar auch erhöhten, aber noch im Rahmen liegenden Freiflächenverschleiß aufweist, während der Freiflächenverschleiß von Muster D beim Fräsen von Sphäroguß gravierend über dem Freiflächenverschleiß des Musters A1 liegt.

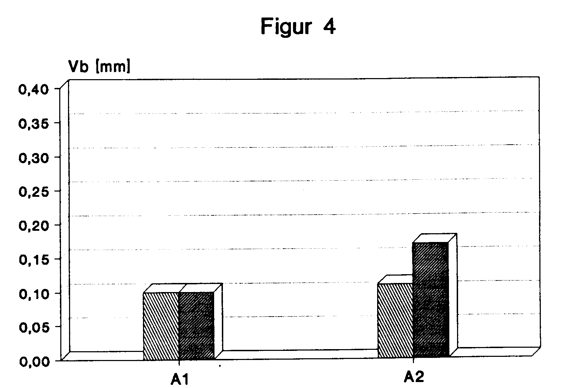

In einem vierten Zerspanungstest wurde Kohlenstoffstahl (CK60) mit einer Schnittgeschwindigkeit von 220 m/min., einem Vorschub von 0,30 mm/U und einer Schnittiefe von 3 mm jeweils unter Verwendung der Muster-Wendeschneidplatten A1, A2 und G über eine Länge von 800 mm trockengefräst und der Verschleiß der einzelnen Muster miteinander verglichen.
Aus Figur 4 ist der Freiflächenverschleiß zu entnehmen.

Durch diesen Test ist klar der Einfluß der Korngröße auf das Zerspanungsverhalten zu ersehen.
Das Muster G mit einem feinkörnigen Grundwerkstoff mit einer Koerzitiv-Feldstärke von 27,06.10³ A/m, aber gleichem Schichtaufbau wie die erfindungsgemäßen Muster A1 und A2 ist durch Schneidkantenbruch vorzeitig ausgefallen, woraus zu ersehen ist, daß feinkörniges Grundmaterial für Zerspanungsaufgaben mit einer hohen Zähigkeitsforderung an das Grundmaterial nicht einsetzbar ist.

Die Beispiele stellen besonders bevorzugte Ausgestaltungen der Erfindung dar. Diese ist jedoch nicht darauf beschränkt.
Wesentlich für die Erfindung ist das Zusammenwirken von speziell abgestimmtem Grundmaterial und Schichtaufbau. Gewisse Abweichungen im Schichtaufbau, die das Verschleißverhalten praktisch nicht beeinflussen, wie beispielsweise eine bis zu 1 µm starke Titannitridschicht zur Farbgebung über der oxidischen Deckschicht, liegen ebenfalls im Bereich der Erfindung.

## Patentansprüche

1. Schneidwerkstoff zum Fräsen von Metallen, bestehend aus einem Hartmetall-Grundkörper der Zusammensetzung 5,5 - 14 Gew.% Kobalt, bis zu 20 Gew.% von einem oder mehreren Zusatzkarbiden der Metalle der Gruppe IV A und V A des Periodensystems der Elemente, wobei im Falle eines Kobaltgehaltes von weniger als 7,5 Gew.% der Anteil der Zusatzkarbide weniger als 5 Gew.% beträgt, Rest Wolframkarbid, sowie aus einer auf dem Hartmetall-Grundkörper aufgebrachten Beschichtung mit einer Gesamtschichtdicke von 2 - 7 µm und, ausgehend vom Hartmetall-Grundkörper, folgendem Schichtaufbau:
- eine ein- oder mehrlagige Unterlagsschicht aus Titankarbonitrid und/oder Titannitrid, wahlweise mit Sauerstoff- und/oder Boranteilen
- eine ein- oder mehrlagige Deckschicht aus einem oder mehreren Oxiden, ausgewählt aus der Gruppe Aluminiumoxid, Zirkonoxid oder deren Mischungen, wahlweise mit Titan- und/oder Boranteilen und wahlweise im Wechsel mit Hartstoffschichten aus der Gruppe Titankarbid, Titannitrid, Titanborid, Titanoxid oder deren Mischungen, wobei der Grundkörper eine Koerzitiv-Feldstärke mit Werten zwischen 6,37.10³ und 14,32.10³ A/m aufweist und der an die Deckschicht angrenzende Bereich der Unterlagsschicht stickstoffreich ist bei einem Stickstoff-Mindestanteil von 40 Atom%,
**dadurch gekennzeichnet**,
daß die Gesamtschichtstärke der Unterlagsschicht 0,5 - 3 µm beträgt.

2. Schneidwerkstoff zum Fräsen von Metallen, bestehend aus einem Hartmetall-Grundkörper der Zusammensetzung 5,5 - 14 Gew.% Kobalt, bis zu 20 Gew.% von einem oder mehreren Zusatzkarbiden der Metalle der Gruppe IV A und V A des Periodensystems der Elemente, wobei im Falle eines Kobaltgehaltes von weniger als 7,5 Gew.% der Anteil der Zusatzkarbide weniger als 5 Gew.% beträgt, Rest Wolframkarbid, sowie aus einer auf dem Hartmetall-Grundkörper aufgebrachten Beschichtung mit einer Gesamtschichtdicke von 2 - 7 µm und, ausgehend vom Hartmetall-Grundkörper, folgendem Schichtaufbau:
- eine ein- oder mehrlagige Unterlagsschicht aus einem oder mehreren Hartstoffen, ausgewählt aus der Gruppe Titankarbid, Titannitrid, Titanoxid, Titanborid oder deren Mischungen; wobei der an die Deckschicht angrenzende Bereich der Unterlagsschicht aus ein- oder mehrlagigen Titankarbonitrid- und/oder Titannitridschichten mit einer Gesamtschichtstärke von 0,5 - 5 µm besteht, wahlweise mit Sauerstoff- und/oder Boranteilen
- eine ein- oder mehrlagige Deckschicht aus einem oder mehreren Oxiden, ausgewählt aus der Gruppe Aluminiumoxid, Zirkonoxid oder deren Mischungen, wahlweise mit Titan- und/oder Boranteilen und wahlweise im Wechsel mit Hartstoffschichten aus der Gruppe Titankarbid, Titannitrid, Titanborid, Titanoxid oder deren Mischungen, wobei der Grundkörper eine Koerzitiv-Feldstärke mit Werten zwischen 6,37.10³ und 14,32.10³ A/m aufweist,
dadurch gekennzeichnet, daß die unmittelbar an die Deckschicht angrenzende Teilschicht der Unterlagsschicht eine Titannitridschicht ist.

3. Schneidwerkstoff nach Anspruch 1 oder 2, dadurch gekennzeichnet, daß der Grundkörper eine Koerzitiv-Feldstärke mit Werten zwischen 7,96.10³ und 12,73.10³ A/m aufweist, der Zusatzkarbidanteil 5 - 15 Gew.% und der Kobaltanteil 8 - 12 Gew.% beträgt.

4. Schneidwerkstoff nach Anspruch 1 oder 2, dadurch gekennzeichnet, daß der Grundkörper eine Koerzitiv-Feldstärke mit Werten zwischen 9,55.10³ und 12,73.10³ A/m aufweist, der Zusatzkarbidanteil weniger als 3 Gew.% und der Kobaltanteil 5,5 - 7 Gew.% beträgt.

5. Schneidwerkstoff nach einem der Ansprüche 1-4, dadurch gekennzeichnet, daß die Unterlagsschicht angrenzend an das Grundmaterial eine oder mehrere Titankarbonitridschichten aufweist.

6. Schneidwerkstoff nach Anpruch 5, dadurch gekennzeichnet, daß zwischen Grundkörper und den Titankarbonitridschichten eine Titannitridschicht angeordnet ist.

7. Schneidwerkstoff nach einem der Ansprüche 1 - 6, dadurch gekennzeichnet, daß der an die Deckschicht angrenzende Bereich der Unterlagsschicht aus ein- oder mehrlagigen Titankarbonitrid- und/oder Titannitridschichten mit einer Gesamtschichtstärke von 0,5 - 3 µm besteht, wobei die Stickstoffgehalte der einzelnen Lagen mindestens 45 Atom% betragen.

8. Schneidwerkstoff nach einem der Ansprüche 1 - 7, dadurch gekennzeichnet, daß die Deckschicht eine einlagige Aluminiumoxidschicht mit einer Schichtstärke von 0,5 - 5 µm ist.

9. Schneidwerkstoff nach einem der Ansprüche 1 - 7, dadurch gekennzeichnet, daß die Deckschicht eine mehrlagige Aluminiumoxidschicht jeweils im Wechsel mit einer Titanoxinitrid- oder Titanoxikarbonitridschicht, mit einer Gesamtschichtstärke zwischen 0,5 und 5 µm ist.

10. Verfahren zur Herstellung eines Schneidwerkstoffes nach Anspruch 1 oder 2, dadurch gekennzeichnet, daß zur Herstellung des Hartmetall-Grundkörpers das Wolframkarbidpulver mit einer mittleren Korngröße zwischen 1,5 µm und 8 µm, das Kobaltpulver mit einer mittleren Korngröße zwischen 1 µm und 3 µm und die Zusatzkarbidpulver mit einer mittleren Korngröße zwischen 1 µm und 3 µm im Attritor zwischen 5 und 15 Stunden gemahlen, gepreßt und bei 1400 - 1500°C zwischen 30 und 120 Minuten gesintert werden und daß der Grundkörper anschließend mittels CVD-, Plasma-CVD- oder PVD-Verfahren beschichtet wird.

## Claims

1. Cutting material for cutting metals which consists of a hard metal substrate having the composition 5.5 to 14 wt.% cobalt, up to 20 wt.% of one or more additional carbides of the metals of Group IV A and Group V A of the periodic system of the elements, the proportion of additional carbides being less than 5 wt.% in the case of a cobalt content of less than 7.5 wt.%, and tungsten carbide as the remainder, as well as of a coating applied to the hard metal substrate, the coating having a total layer thickness of from 2 to 7 µm and, starting from the hard metal substrate, the following layer structure:
- a single-layer or multilayered backing layer of titanium carbonitride and/or titanium nitride, alternatively containing oxygen and or boron
- a single-layer or multilayered outer layer composed of one or more oxides, selected from the group comprising aluminium oxide, zirconium oxide or mixtures thereof, alternatively containing titanium and or boron and alternatively in alternation with layers of hard material selected from the group comprising titanium carbide, titanium nitride, titanium boride, titanium oxide or mixtures thereof, the substrate having a coercivity with values between 6.37 . 10³ A/m and 14.32 . 10³ A/m and the region of the backing layer adjacent to the outer layer being nitrogen-rich, with a minimum nitrogen content of 40 atom%,
characterised in that
the total layer thickness of the backing layer is from 0.5 to 3 µm.

2. Cutting material for cutting metals which consists of a hard metal substrate having the composition 5.5 to 14 wt.% cobalt, up to 20 wt.% of one or more additional carbides of the metals of Group IV A and Group V A of the periodic system of the elements, the proportion of additional carbides being less than 5 wt.% in the case of a cobalt content of less than 7.5 wt.%, and tungsten carbide as the remainder, as well as of a coating applied to the hard metal substrate, the coating having a total layer thickness of from 2 to 7 µm and, starting from the hard metal substrate, the following layer structure:
- a single-layer or multilayered backing layer composed of layers of hard material selected from the group comprising titanium carbide, titanium nitride, titanium oxide, titanium boride or mixtures thereof; the region of the backing layer adjacent to the outer layer being composed of a single-layer or multilayered titanium carbonitride layer and/or titanium nitride layer having a total layer thickness of from 0.5 to 5 µm, alternatively containing oxygen and/or boron
- a single-layer or multilayered outer layer composed of one or more oxides, selected from the group comprising aluminium oxide, zirconium oxide or mixtures thereof, alternatively containing titanium and or boron and alternatively in alternation with layers of hard material from the group comprising titanium carbide, titanium nitride, titanium boride, titanium oxide or mixtures thereof, the substrate having a coercivity with values between 6.37 . 10³ A/m and 14.32 . 10³ A/m,
characterised in that the sublayer of the backing layer immediately adjacent to the outer layer is a titanium nitride layer.

3. Cutting material according to claim 1 or 2, characterised in that the substrate has a coercivity with values between 7.96 . 10³ A/m and 12.73 . 10³ A/m, the content of additional carbides is 5 to 15 wt.% and the cobalt content is 8 to 12 wt.%.

4. Cutting material according to claim 1 or 2, characterised in that the substrate has a coercivity with values between 9.55 . 10³ A/m and 12.73 . 10³ A/m, the content of additional carbides is less than 3 wt.% and the cobalt content is 5.5 to 7 wt.%.

5. Cutting material according to one of claims 1 to 4, characterised in that the backing layer adjacent to the substrate material contains one or more titanium carbonitride layers.

6. Cutting material according to claim 5, characterised in that a titanium nitride layer is arranged between the substrate and the titanium carbonitride layers.

7. Cutting material according to one of claims 1 to 6, characterised in that the region of the backing layer adjacent to the outer layer consists of single-layer or multilayered titanium carbonitride layers and/or titanium nitride layers having a total layer thickness of from 0.5 to 3 µm, the nitrogen contents of the individual layers amounting to at least 45 atoms%.

8. Cutting material according to one of claims 1 to 7, characterised in that the outer layer is a single-layer aluminium oxide layer having a layer thickness of from 0.5 to 5 µm.

9. Cutting material according to one of claims 1 to 7, characterised in that the outer layer is a multilayered aluminium oxide layer, each layer alternating with a titanium oxynitride layer or titanium oxycarbonitride layer having a total layer thickness of between 0.5 and 5 µm.

10. Process for the production of a cutting material according to claim 1 or 2, characterised in that in order to produce the hard metal substrate, the tungsten carbide powder having an average particle size of between 1.5 µm and 8 µm, the cobalt powder having an average particle size of between 1 µm and 3 µm and the powdered additional carbide having an average particle size of between 1 µm and 3 µm are milled for between 5 and 15 hours in an attritor, pressed and then sintered at 1400°C to 1500°C for between 30 and 120 minutes and that the substrate is subsequently coated by means of CVD, plasma-CVD or PVD processes.

## Revendications

1. Matériau de coupe pour le fraisage de métaux, qui se compose d'un corps de base en métal dur dont la composition est de 5,5 à 14% en poids de cobalt, jusqu'à 10% en poids d'un ou plusieurs carbures additionnels des métaux des groupes IV A et V A du système périodique des éléments, la teneur en carbures additionnels étant inférieure à 5% en poids lorsque la teneur en cobalt est inférieure à 7,5% en poids, le solde consistant en carbure de tungstène, ainsi que d'un revêtement appliqué sur le corps de base en métal dur, d'une épaisseur totale de couche de 2 à 7 µm et, dont la structure de couche est la suivante, en partant du corps de base en métal dur:
- une couche sous-jacente à une ou plusieurs strates en carbonitrure de titane et/ou en nitrure de titane, contenant facultativement des teneurs en oxygène et/ou en bore,
- une couche de recouvrement à une ou plusieurs strates en un ou plusieurs oxydes choisis dans le groupe formé par l'oxyde d'aluminium, l'oxyde de zirconium, ou leurs mélanges, contenant facultativement des teneurs en titane ou en bore et contenant facultativement en variante des couches de matériaux durs du groupe formé par le carbure de titane, le nitrure de titane, le borure de titane, l'oxyde de titane ou leurs mélanges, le corps de base présentant une intensité de champ coercitif dont les valeurs sont comprises entre 6,37.10³ et 14,32.10³ A/m et la zone de la couche sous-jacente, adjacente à la couche de recouvrement, étant riche en oxygène selon une teneur atomique minimale en oxygène de 40%,
caractérisé en ce que
l'épaisseur totale de couche de la couche sous-jacente est de 0,5 à 3 µm.

2. Matériau de coupe pour le fraisage de métaux, qui se compose d'un corps de base en métal dur dont la composition est de 5,5 à 14% en poids de cobalt, jusqu'à 20% en poids d'un ou plusieurs carbures additionnels des métaux des groupes IV A et V A du système périodique des éléments, la teneur en carbures additionnels étant inférieure à 5% en poids lorsque la teneur en cobalt est inférieure à 7,5% en poids, le solde consistant en carbure de tungstène, ainsi que d'un revêtement appliqué sur le corps de base en métal dur, d'une épaisseur totale de couche de 2 à 7 µm et, dont la structure de couche est la suivante, en partant du corps de base en métal dur:
- une couche sous-jacente à une ou plusieurs strates en un ou plusieurs matériaux durs choisis dans le groupe formé par le carbure de titane, le nitrure de titane, l'oxyde de titane, le borure de titane ou leurs mélanges, la zone de la couche sous-jacente qui est adjacente à la couche de recouvrement se composant de couches de carbonitrure de titane et/ou de nitrure de titane en une ou plusieurs strates, d'une épaisseur totale de couche de 0,5 à 5 µm, contenant facultativement des teneurs en oxygène et/ou en bore,
- une couche de recouvrement à une ou plusieurs strates en un ou plusieurs oxydes choisis dans le groupe formé par l'oxyde d'aluminium, l'oxyde de zirconium, ou leurs mélanges, contenant facultativement des teneurs en titane et/ou en bore et contenant facultativement en variante des couches de matériaux durs du groupe formé par le carbure de titane, le nitrure de titane, le borure de titane, l'oxyde de titane ou leurs mélanges, le corps de base présentant une intensité de champ coercitif dont les valeurs sont comprises entre 6,37.10³ et 14,32.10³ A/m,
caractérisé en ce que la couche partielle de la couche sous-jacente qui est adjacente à la couche supérieure est une couche de nitrure de titane.

3. Matériau de coupe selon la revendication 1 ou 2, caractérisé en ce que le corps de base présente une intensité de champ coercitive dont les valeurs sont comprises entre 7,96.10³ et 12,73.10³ A/m, la teneur en carbures additionnels est de 5 à 15% en poids et la teneur en cobalt est de 8 à 12% en poids.

4. Matériau de coupe selon la revendication 1 ou 2, caractérisé en ce que le corps de base présente une intensité de champ coercitive dont les valeurs sont comprises entre 9,55.10³ et 12,73.10³ A/m, la teneur en carbures additionnels est inférieure à 3% en poids et la teneur en cobalt est de 5,5 à 7% en poids.

5. Matériau de coupe selon l'une des revendications 1 à 4, caractérisé en ce que la couche sous-jacente comporte une ou plusieurs couches de carbonitrure de titane adjacentes au matériau de base.

6. Matériau de coupe selon la revendication 5, caractérisé en ce qu'une couche de nitrure de titane est agencée entre le corps de base et les couches de carbonitrure de titane.

7. Matériau de coupe selon l'une des revendications 1 à 6, caractérisé en ce que la zone de la couche sousjacente qui est adjacente à la couche de recouvrement se compose de couches de carbonitrure de titane et/ou de nitrure de titane à une ou plusieurs strates, d'une épaisseur totale de couche de 0,5 à 3 µm, les teneurs atomiques des couches individuelles en oxygène étant d'au moins 45%.

8. Matériau de coupe selon l'une des revendications 1 à 7, caractérisé en ce que la couche de recouvrement est une couche d'oxyde d'aluminium à strate unique d'une épaisseur de couche de 0,5 à 5 µm.

9. Matériau de coupe selon l'une des revendications 1 à 7, caractérisé en ce que la couche de recouvrement est une couche d'oxyde d'aluminium à plusieurs strates respectivement alternées avec une couche d'oxynitrure de titane et d'oxycarbonitrure de titane, d'une épaisseur totale de couche comprise entre 0,5 et 5 µm.

10. Procédé de fabrication d'un matériau de coupe selon l'une des revendications 1 ou 2, caractérisé en ce que, pour la fabrication du corps de base en métal dur, la poudre de carbure de tungstène d'une' granulométrie moyenne comprise entre 1,5 µm et 8 µm, la poudre de cobalt d'une granulométrie moyenne comprise entre 1 µm et 3 µm et la poudre de carbures additionnels d'une granulométrie moyenne comprise entre 1 µm et 3 µm sont broyées dans un broyeur par attrition pendant 5 à 15 heures, comprimées et frittées à 1.400 à 1.500°C pendant 30 à 120 minutes, et en ce que le corps de base est ensuite revêtu par des procédés de dépôt chimique en phase vapeur ou CVD, de dépôt chimique en phase vapeur assisté par plasma ou plasma-CVD, ou de dépôt physique en phase vapeur ou PVD.
